# EUROPÄISCHE PATENTANMELDUNG

(11) **EP 2 876 989 A1**
(43) Veröffentlichungstag der Anmeldung: **27.05.2015**
(21) Anmeldenummer: 14194672.3
(22) Anmeldetag: 25.11.2014
(51) Int. Cl.: H05K 7/20

(54) **Luftdurchtrittsvorrichtung zur Zuführung gereinigter Luft in einen Innenraum eines Schaltschrankes**

(30) Priorität: 25.11.2013 DE 102013112977
(71) Anmelder: Pfannenberg GmbH, 21035 Hamburg (DE)
(72) Erfinder: Pfannenberg, Andreas, 21035 Hamburg (DE); Starp, Peter, 21035 Hamburg (DE)
(74) Vertreter: RGTH

(57) **Zusammenfassung**

Um eine Luftdurchtrittsvorrichtung zur Zuführung und Reinigung von Luft, insbesondere Umgebungsluft, in den Innenraum eines Schaltschrankes oder eines Computergehäuses derart auszugestalten, dass die Vorrichtung auch in einer Umgebung mit höherem Verschmutzungsgrad verwendet werden kann, wird vorgeschlagen, ein erstes Luftreinigungsmittel der Luftdurchtrittsvorrichtung als Fliehkraftabscheider auszubilden.

## Beschreibung

### Technisches Gebiet

Die Erfindung betrifft eine Luftdurchtrittsvorrichtung zur Zuführung von Luft, insbesondere Umgebungsluft, in einen Innenraum eines Schaltschrankes oder eines Computergehäuses, insbesondere Servergehäuses, wobei die Luft vor Zuführung in den Innenraum des Schaltschrankes oder des Computergehäuses gereinigt wird.

Ferner betrifft die Erfindung einen Schaltschrank mit einer Luftdurchtrittsvorrichtung zur Zuführung von gereinigter Luft in dessen Innenraum.

### Stand der Technik

Schaltschränke weisen elektrische und/oder elektronische Komponenten einer verfahrenstechnischen Anlage, einer Werkzeugmaschine oder Fertigungseinrichtung auf, wobei diese Komponenten in der Regel nicht direkt in der Maschine angeordnet sind.

Die im Schaltschrank angeordneten elektrischen und/oder elektronischen Komponenten werden durch den Schaltschrank unter anderem vor Staub, Aerosolen und Feuchtigkeit geschützt. Des Weiteren muss der Innenraum eines Schaltschrankes vor Überhitzung geschützt werden.

Zum Schutz des Innenraums eines Schaltschrankes vor Überhitzung werden üblicherweise Schaltschrankklimatisierungsvorrichtungen, beispielsweise Kühlaggregate oder Wärmetauscher eingesetzt. In Abhängigkeit von der Umgebung, in welcher der Schaltschrank eingesetzt wird, können auch Filterlüfter oder Kühlluftöffnungen mit Ventilator ausreichend sein. Insbesondere in Umgebungen, in welchen höhere Staubbelastungen oder höhere Aerosolbelastungen, beispielsweise durch feste oder flüssige Schwebeteilchen in der Luft bestehen, können Kühlluftöffnungen mit Ventilatoren sowie Filterlüfter nicht eingesetzt werden. Durch die Öffnungen im Schaltschrank können die Staubpartikel, Aerosole, sowie auch die Feuchtigkeit in das Schaltschrankinnere eintreten. Bei Filterlüftern ist ein sehr häufiges Austauschen der Filtermaterialien aufgrund der höheren Staubbelastung oder Aerosolbelastung in der Umgebungsluft notwendig.

In Umgebungen mit höherer Staubbelastung, Aerosolbelastung und/oder höherer Feuchtigkeit werden deshalb geschlossene, beziehungsweise vollständig schließbare Schaltschränke eingesetzt, welche mittels zusätzlicher Kühlaggregate oder Wärmetauscher gekühlt werden. Die Umgebungsluft kann somit nicht in den Innenraum des Schaltschrankes eintreten. Computer, Großrechner und Server werden ebenfalls in staubbelasteten Umgebungen sowie in Umgebungen mit höherer Luftfeuchtigkeit eingesetzt. Deshalb tritt dieselbe Problematik wie bei Schaltschränken auch bei der Kühlung der Innenräume von Computergehäusen auf.

### Darstellung der Erfindung: Aufgabe, Lösung, Vorteile

Aufgabe der vorliegenden Erfindung ist es, eine Luftdurchtrittsvorrichtung zur Zuführung von gereinigter Luft, insbesondere Umgebungsluft, in einen Innenraum eines Schaltschranks oder eines Computergehäuses bereitzustellen, welche auch in Umgebungen mit höherer Belastung einsetzbar ist.

Unter Belastung ist jegliche Belastung in der Luft, insbesondere ein höherer Verschmutzungsgrad zu verstehen. Insbesondere ist hierunter Staubbelastung, Aerosolbelastung, ölhaltige Luft sowie emulsionshaltige Luft zu verstehen.

Erfindungsgemäß wird eine Luftdurchtrittsvorrichtung zur Zuführung von Luft, insbesondere Umgebungsluft, in einen Innenraum eines Schaltschrankes oder eines Computergehäuses vorgeschlagen, wobei die Luftdurchtrittsvorrichtung ein erstes Luftreinigungsmittel zur Reinigung der durch die Luftdurchtrittsvorrichtung durchzuführenden Luft aufweist. Ferner ist am oder im Gehäuse der Luftdurchtrittsvorrichtung ein Luftfördermittel zum Zuführen der von dem ersten Luftreinigungsmittel zu reinigenden Luft zum ersten Luftreinigungsmittel angeordnet. Des Weiteren weist die Luftdurchtrittsvorrichtung erfindungsgemäß ein Gehäuse auf. Das erste Luftreinigungsmittel ist als Fliehkraftabscheider ausgebildet.

Die Luftdurchtrittsvorrichtung kann durch das Gehäuse vollständig geschlossen oder auch nur teilweise geschlossen ausgebildet sein. Die Luftdurchtrittsvorrichtung ist bevorzugterweise am oder im Bereich eines Schaltschrankes oder eines Computergehäuses anordbar.

Unter einem Schaltschrank ist ein Gehäuse mit elektrischen und/oder elektronischen Komponenten einer verfahrenstechnischen Anlage, einer Werkzeugmaschine oder einer Fertigungseinrichtung zu verstehen, wobei diese elektrischen und/oder elektronischen Komponenten bevorzugterweise nicht direkt in der Maschine angeordnet sind. Des Weiteren ist die Luftdurchtrittsvorrichtung zur Zuführung von gereinigter Luft, insbesondere Umgebungsluft, in den Innenraum eines Computergehäuses, insbesondere eines Servergehäuses, ausgebildet.

Zur Reinigung der Luft, insbesondere der Umgebungsluft, vor Zuführung in den Innenraum eines Schaltschrankes oder eines Computergehäuses ist zumindest ein erstes Luftreinigungsmittel vorgesehen. Das erste Luftreinigungsmittel ist dabei als Fliehkraftausscheider ausgebildet. Ferner ist das erste Luftreinigungsmittel bevorzugterweise im Innenraum der Luftdurchtrittsvorrichtung angeordnet, wobei der Innenraum der Luftdurchtrittsvorrichtung durch das Gehäuse der Luftdurchtrittsvorrichtung eingegrenzt beziehungsweise eingeschlossen ist. Bevorzugterweise weist das erste Luftreinigungsmittel keinen Filter, insbesondere kein Filterelement, beispielsweise eine Filtermatte, auf.

Vorzugsweise ist nur ein erstes Luftreinigungsmittel und somit kein weiteres Luftreinigungsmittel vorgesehen. Dabei ist bevorzugterweise vorgesehen, dass die gesamte Luftdurchtrittsvorrichtung keinen Filter, insbesondere kein Filterelement, beispielsweise eine Filtermatte, aufweist und somit filterlos ausgebildet ist.

Unter einem Fliehkraftabscheider ist beispielsweise ein Zyklonabscheider zu verstehen. Der Fliehkraftabscheider dient zur Absonderung von in Gasen (beispielsweise in der Umgebungsluft) enthaltenen festen oder flüssigen Partikeln. Somit kann mit dem Fliehkraftabscheider beispielsweise staubhaltige Umgebungsluft gereinigt werden. Dabei wird die Luft als Träger durch die eigene Strömungsgeschwindigkeit und entsprechende konstruktive Gestaltung des Fliehkraftabscheiders in eine Drehbewegung versetzt. Die auf die in der Luft enthaltenen Partikel wirkenden Zentrifugalkräfte beschleunigen diese radial nach außen. Sie werden dadurch vom Luftstrom getrennt, der nach innen geleitet und abgeführt wird.

Bevorzugterweise weist der Fliehkraftabscheider im oberen Bereich einen Einlaufzylinder und im mittigen und/oder unteren Bereich einen kegelförmigen Abschnitt auf. Des Weiteren ist bevorzugterweise vorgesehen, dass der Fliehkraftabscheider einen Partikelauffangbehälter im unteren Bereich aufweist. Mittig und von oben hineinragend in den Einlaufzylinder ist ein Tauchrohr angeordnet. Die Luft wird im oberen Bereich dem Einlaufzylinder zugeführt. Durch die Trennung von Schmutzpartikeln und Luft im Inneren des Einlaufzylinders, beziehungsweise im unterhalb des Einlaufzylinders angeordneten kegelförmigen Abschnitt, werden die Schmutzpartikel durch den Partikelauffangbehälter aufgefangen und in diesem gesammelt. Die von den Partikeln getrennte, beziehungsweise zumindest teilweise gereinigte, Luft steigt durch das Tauchrohr nach oben auf.

Durch das Vorsehen einer Luftdurchtrittsvorrichtung mit einem Fliehkraftabscheider als erstes Luftreinigungsmittel kann der Innenraum eines Schaltschrankes oder eines Computergehäuses durch Zuführung von gereinigter Luft gekühlt werden. Somit ist eine aufwendigere und teure Klimatisierungsvorrichtung, wie beispielsweise ein Kühlaggregat oder ein Wärmeübertrager, beispielsweise ein Wärmetauscher oder Wärmeaustauscher, nicht notwendig. Durch das Vorsehen eines Fliehkraftabscheiders als erstes Luftreinigungsmittel kann ein häufiges Wechseln von Filterelementen vermieden werden. Mit dem Partikelauffangbehälter eines Fliehkraftabscheiders können Schmutzpartikel über einen längeren Zeitraum gesammelt werden, als dies beispielsweise bei Filterelementen, wie Filtermatten, möglich ist. Dies ist insbesondere bei stark belasteter Umgebungsluft ein entscheidender Vorteil. Des Weiteren kann der Partikelauffangbehälter des Fliehkraftabscheiders in einfacher Weise entleert werden. Ein Austausch eines Filterelementes ist hier nicht notwendig. Somit ist das Vorsehen einer Luftdurchtrittsvorrichtung mit Fliehkraftabscheider auch während des Betriebs kostengünstig und wartungsarm.

Vorteilhaft ist ferner, dass mit einer filterlos ausgebildeten Luftdurchtrittsvorrichtung eine druckverlustfreie oder zumindest druckverlustreduzierte Vorrichtung bereitgestellt werden kann. Aus dem Stand der Technik bekannte Anordnungen mit Filterelementen, beispielsweise Filtermatten, weisen bereits durch das Filterelement einen Druckverlust auf. Mit zunehmender Verschmutzung des Filterelements nimmt der Druckverlust durch derartige Anordnungen somit weiter zu.

Bevorzugterweise weist die Luftdurchtrittsvorrichtung eine erste Lufteintrittsöffnung für den Einlass der Luft in den Innenraum der Luftdurchtrittsvorrichtung auf. Durch die erste Lufteintrittsöffnung kann der Luftdurchtrittsvorrichtung die zu reinigende Luft zugeführt werden. Des Weiteren ist bevorzugterweise vorgesehen, dass die Luftdurchtrittsvorrichtung eine erste Luftauslassöffnung für den Auslass der gereinigten Luft aufweist. Durch die erste Luftauslassöffnung kann die gereinigte Luft aus dem Innenraum der Luftdurchtrittsvorrichtung hinaus geleitet werden und dem Innenraum des Schaltschrankes oder Computergehäuses zugeführt werden.

Bevorzugterweise ist sowohl die erste Lufteintrittsöffnung sowie auch die erste Luftauslassöffnung im Gehäuse der Luftdurchtrittsvorrichtung angeordnet. Die erste Lufteintrittsöffnung sowie die erste Luftauslassöffnung können dabei an jeder geeigneten Stelle des Gehäuses der Luftdurchtrittsvorrichtung angeordnet sein. Besonders bevorzugterweise sind die erste Lufteintrittsöffnung und die erste Luftauslassöffnung in der oberen und/oder unteren Hälfte des Gehäuses der Luftdurchtrittsvorrichtung angeordnet. Somit ist bevorzugterweise vorgesehen, dass sowohl die erste Lufteintrittsöffnung sowie auch die erste Luftauslassöffnung nicht mittig im Gehäuse der Luftdurchtrittsvorrichtung angeordnet sind. Des Weiteren ist bevorzugterweise vorgesehen, dass die erste Lufteintrittsöffnung und die erste Luftauslassöffnung in verschiedenen Hälften, insbesondere aneinander gegenüberliegenden Enden, des Gehäuses der Luftdurchtrittsvorrichtung angeordnet sind. Beispielsweise können die erste Lufteintrittsöffnung im oberen Bereich, beziehungsweise in der oberen Hälfte, des Gehäuses der Luftdurchtrittsvorrichtung und die erste Luftauslassöffnung im unteren Bereich, beziehungsweise in der unteren Hälfte, des Gehäuses der Luftdurchtrittsvorrichtung angeordnet sein.

Des Weiteren sind die erste Lufteintrittsöffnung und die erste Luftauslassöffnung vorzugsweise an unterschiedlichen Seitenwänden angeordnet. Beispielsweise können die erste Lufteintrittsöffnung an einer ersten Seitenwand des Gehäuses der Luftdurchtrittsvorrichtung und die erste Luftauslassöffnung in einer zweiten Seitenwand des Gehäuses der Luftdurchtrittsvorrichtung angeordnet sein.

Die erste Lufteintrittsöffnung sowie die erste Luftauslassöffnung können jede geeignete Form, beziehungsweise jeden geeigneten Querschnitt aufweisen. Bevorzugterweise weist die erste Lufteintrittsöffnung und/oder die erste Luftauslassöffnung einen runden, ovalen oder eckigen, beispielsweise rechteckigen oder quadratischen, Querschnitt auf.

Es ist bevorzugt, dass die Luftdurchtrittsvorrichtung im Wesentlichen quaderförmig ausgebildet ist. Hierzu weist die Luftdurchtrittsvorrichtung vorzugsweise eine größere Höhe als Breite und/oder Tiefe auf. Bevorzugterweise weist die Luftdurchtrittsvorrichtung, beziehungsweise das Gehäuse der Luftdurchtrittsvorrichtung, eine Höhe im Bereich zwischen 200 mm und 2000 mm, besonders bevorzugterweise zwischen 400 mm und 1800 mm auf. Ferner weist die Luftdurchtrittsvorrichtung bevorzugterweise eine Breite zwischen 200 mm und 600 mm, besonders bevorzugterweise zwischen 250 mm und 500 mm auf. Des Weiteren ist bevorzugterweise eine Tiefe zwischen 100 mm und 600 mm, besonders bevorzugterweise zwischen 150 mm und 300 mm vorgesehen.

Das erste Luftreinigungsmittel kann in jeder geeigneten Weise innerhalb der Luftdurchtrittsvorrichtung angeordnet sein. Das erste Luftreinigungsmittel weist eine Eintrittsöffnung auf, durch welche die zu reinigende Luft dem ersten Luftreinigungsmittel zugeführt wird. Beispielsweise kann das erste Luftreinigungsmittel direkt an einer Innenwand der Luftdurchtrittsvorrichtung angeordnet sein. Dabei ist das erste Luftreinigungsmittel mit seiner Eintrittsöffnung im Bereich der ersten Lufteintrittsöffnung der Luftdurchtrittsvorrichtung angeordnet. Dadurch kann die zu reinigende Luft direkt durch die erste Lufteintrittsöffnung der Luftdurchtrittsvorrichtung und durch die Eintrittsöffnung des ersten Luftreinigungsmittels hindurchströmen. Bevorzugterweise ist das erste Luftreinigungsmittel innerhalb der Luftdurchtrittsvorrichtung beabstandet zu den Seitenwänden der Luftdurchtrittsvorrichtung angeordnet. Dabei ist ferner bevorzugterweise vorgesehen, dass die erste Lufteintrittsöffnung der Luftdurchtrittsöffnung über einen Eintrittskanal mit der Eintrittöffnung des ersten Luftreinigungsmittels zur Weiterleitung der Luft an das erste Luftreinigungsmittel verbunden ist.

Ferner ist bevorzugterweise vorgesehen, dass das erste Luftreinigungsmittel mehrere Fliehkraftabscheider aufweist. Beispielsweise können zwei Fliehkraftabscheider vorgesehen sein. Des Weiteren sind bevorzugterweise zwischen einem und zwölf Fliehkraftabscheider vorgesehen. Dabei können die einzelnen Fliehkraftabscheider innerhalb eines Gehäuses des ersten Luftreinigungsmittels angeordnet sein oder separat im Innenraum der Luftdurchtrittsvorrichtung angeordnet sein. Die einzelnen Fliehkraftabscheider können in Strömungsrichtung hintereinander angeordnet sein. Die zu reinigende Luft durchströmt dabei die einzelnen Fliehkraftabscheider nacheinander. Dadurch kann eine mehrstufige Reinigung durch das erste Luftreinigungsmittel erreicht werden. Alternativerweise oder zusätzlich können mehrere Fliehkraftabscheider parallel zu einander angeordnet sein. Die parallele Anordnung bezieht sich dabei auf den Luftstrom. Bei einer parallelen Anordnung mehrerer Fliehkraftabscheider zueinander, kann die zu reinigende Luft im Wesentlichen gleichzeitig in die einzelnen Fliehkraftabscheider eintreten. Ferner wird dadurch die zu reinigende Luft auf mehrere Fliehkraftabscheider verteilt. Ein gemeinsamer Zuluftkanal und/oder Abluftkanal für die einzelnen Fliehkraftabscheider kann vorgesehen sein. Beispielsweise könnte das erste Luftreinigungsmittel mehrstufig ausgebildet sein, wobei in einer ersten Stufe ein Fliehkraftabscheider angeordnet ist und in Strömungsrichtung daran anschließend eine zweite Stufe mit einem oder mehreren parallel zueinander angeordneten Fliehkraftabscheider angeordnet ist. Auch könnten in der ersten Stufe mehrere parallel zueinander angeordnete Fliehkraftabscheider vorgesehen sein. Ferner können mehr als zwei Stufen vorgesehen sein.

Der Eintrittskanal, der die erste Lufteintrittsöffnung der Luftdurchtrittsvorrichtung mit der Eintrittsöffnung des ersten Luftreinigungsmittels verbindet, kann jede geeignete Form, beziehungsweise jeden geeigneten Querschnitt, aufweisen. Beispielsweise kann der Eintrittskanal rohrartig oder schlauchartig sowie als Rohr oder Schlauch ausgebildet sein. Der Eintrittskanal kann einen runden, ovalen oder eckigen Querschnitt aufweisen. Die Eintrittsöffnung des ersten Luftreinigungsmittels ist bevorzugterweise im oberen Bereich des ersten Luftreinigungsmittels, das heißt, zumindest in der oberen Hälfte des ersten Luftreinigungsmittels, angeordnet. Somit ist die Eintrittsöffnung des Fliehkraftabscheiders im Bereich des Einlaufzylinders sowie im oberen Bereich des Einlaufzylinders angeordnet.

Die erste Lufteintrittsöffnung der Luftdurchtrittsvorrichtung und die Eintrittsöffnung des ersten Luftreinigungsmittels können dieselbe Form, beziehungsweise dieselbe Querschnittsfläche, oder eine voneinander unterschiedliche Form, beziehungsweise voneinander unterschiedliche Querschnittfläche, aufweisen. Beispielsweise kann die erste Lufteintrittsöffnung der Luftdurchtrittsvorrichtung und/oder die Eintrittsöffnung des ersten Luftreinigungsmittels einen runden, ovalen oder eckigen Querschnitt aufweisen. Bevorzugterweise ist die erste Lufteintrittsöffnung der Luftdurchtrittsvorrichtung größer als die Eintrittsöffnung des ersten Luftreinigungsmittels ausgebildet. Hierunter ist zu verstehen, dass die erste Lufteintrittsöffnung einen größeren Querschnitt beziehungsweise eine größere Öffnungsfläche aufweist als die Eintrittsöffnung des ersten Luftreinigungsmittels. Beispielsweise kann die erste Lufteintrittsöffnung eine größere Breite und/oder Höhe als die Eintrittsöffnung des ersten Luftreinigungsmittels aufweisen.

Ferner ist der Eintrittskanal bevorzugterweise derart ausgebildet, dass dessen Querschnitt von der ersten Lufteintrittsöffnung hin zur Eintrittsöffnung des ersten Luftreinigungsmittels abnimmt. Besonders bevorzugterweise nimmt der Querschnitt des Eintrittskanals dabei stetig ab. Unter stetig ist zu verstehen, dass der Querschnitt von der ersten Lufteintrittsöffnung hin zur Eintrittsöffnung des ersten Luftreinigungsmittels in keinem Bereich zunimmt. Somit nimmt der Querschnitt des Eintrittskanals von der ersten Lufteintrittsöffnung hin zur Eintrittsöffnung des ersten Luftreinigungsmittels in jedem Bereich ab oder ist bereichsweise zumindest gleichbleibend. Beispielsweise kann der Eintrittskanal konisch, kegelförmig oder trichterförmig ausgebildet sein.

Die Eintrittsöffnung des ersten Luftreinigungsmittels oder der Eintrittskanal ist bezogen auf eine Längsmittelachse des ersten Luftreinigungsmittels oder bezogen auf eine Längsmittelachse des Einlaufzylinders des ersten Luftreinigungsmittels bevorzugterweise versetzt zu dieser Längsmittelachse angeordnet. Somit ist bevorzugterweise vorgesehen, dass die Luftzuführung in das erste Luftreinigungsmittel nicht mittig, sondern tangential angeordnet ist. Die zu reinigende Luft wird dem ersten Luftreinigungsmittel somit tangential, das heißt, im seitlichen Bereich des Einlaufzylinders des ersten Luftreinigungsmittels zugeführt. Durch die tangentiale Einströmung wird die Luft nicht mittig bezogen auf die Längsmittelachse des ersten Luftreinigungsmittels oder bezogen auf die Längsmittelachse des Einlaufzylinders des ersten Luftreinigungsmittels in den Einlaufzylinder des ersten Luftreinigungsmittels zugeführt, sondern versetzt auf die Innenwand des Einlaufzylinders des ersten Luftreinigungsmittels geleitet. Unter Längsmittelachse des ersten Luftreinigungsmittels, beziehungsweise unter Längsmittelachse des Einlaufzylinders des ersten Luftreinigungsmittels, ist die mittig angeordnete Längsachse des ersten Luftreinigungsmittels, beziehungsweise des Einlaufzylinders des ersten Luftreinigungsmittels, zu verstehen. Bevorzugterweise ist das erste Luftreinigungsmittel in dessen Längsrichtung vertikal innerhalb der Luftdurchtrittsvorrichtung angeordnet. Somit ist bevorzugterweise vorgesehen, dass die Eintrittsöffnung des ersten Luftreinigungsmittels oder der Eintrittskanal bezogen auf die vertikale Mittelachse des ersten Luftreinigungsmittels, beziehungsweise bezogen auf die vertikale Mittelachse des Einlaufzylinders des ersten Luftreinigungsmittels, versetzt angeordnet ist.

Außerdem ist der Eintrittskanal bevorzugterweise derart ausgebildet, dass ein Endbereich des Eintrittskanals in das erste Luftreinigungsmittel hineinragt. Somit ist bevorzugterweise vorgesehen, dass der Eintrittskanal über eine erste Länge durch die Eintrittsöffnung des ersten Luftreinigungsmittels in das erste Luftreinigungsmittel hineinragt. Dabei kann der Eintrittskanal einstückig oder mehrstückig ausgebildet sein. Des Weiteren kann der Endbereich des Eintrittskanals im Bereich der ersten Länge jede geeignete Form beziehungsweise jeden geeigneten Querschnitt aufweisen. Beispielsweise kann der Endbereich des Eintrittskanals über die gesamte erste Länge einen konstanten oder abnehmenden Querschnitt aufweisen. Bevorzugterweise ist der Endbereich des Eintrittskanals über dessen erste Länge zylinderförmig ausgebildet. Ferner ist bevorzugterweise vorgesehen, dass die erste Länge, über welche der Eintrittskanal mit seinem Endbereich in das erste Luftreinigungsmittel hineinragt, kleiner als der halbe Durchmesser des Einlaufzylinders des ersten Luftreinigungsmittels im Bereich der Eintrittsöffnung des ersten Luftreinigungsmittels ist. Auch ist bevorzugterweise vorgesehen, dass der Eintrittskanal mit dessen Endbereich beabstandet zum Tauchrohr innerhalb des Einlaufzylinders des ersten Luftreinigungsmittels angeordnet ist.

Bevorzugterweise ist der in das erste Luftreinigungsmittel hineinragende Endbereich des Eintrittskanals bezogen auf die Längsmittelachse des ersten Luftreinigungsmittels und/oder bezogen auf die Längsmittelachse des Einlaufzylinders des ersten Luftreinigungsmittels zur tangentialen Einströmung der Luft in den Einlaufzylinder des ersten Luftreinigungsmittels versetzt angeordnet.

Des Weiteren ist bevorzugterweise vorgesehen, dass der Endbereich des in das erste Luftreinigungsmittel hineinragenden Eintrittskanals nach unten geneigt, beispielsweise nach unten geknickt oder gebogen angeordnet ist. Ferner kann der Eintrittskanal über seine gesamte Länge schräg nach unten gerichtet angeordnet sein. Die Längsmittelachse des Eintrittskanals und/oder eine Seitenwand des Eintrittskanals ist somit vorzugsweise zumindest in einem Bereich nicht senkrecht zur Seitenwand des Einlaufzylinders des ersten Luftreinigungsmittels angeordnet. Das bedeutet, dass die Längsmittelachse des Eintrittskanals und/oder eine Seitenwand des Eintrittskanals zumindest bereichsweise in einem Winkel zur Seitenwand des Einlaufzylinders des ersten Luftreinigungsmittels steht, wobei dieser Winkel kleiner als 90 ° ist. Somit ist der Eintrittskanal zumindest mit dessen Endbereich derart ausgebildet, dass die Luftzuführung in den Einlaufzylinder des ersten Luftreinigungsmittels nicht senkrecht auf die Innenwand des Einlaufzylinders des ersten Luftreinigungsmittels, sondern in einem Winkel kleiner als 90° zur Innenwand des Einlaufzylinders des ersten Luftreinigungsmittels angeordnet ist.

Der Innenraum der Luftdurchtrittsvorrichtung weist bevorzugterweise zumindest zwei Bereiche auf. Dabei ist der erste Bereich von dem zweiten Bereich des Innenraums der Luftdurchtrittsvorrichtung räumlich durch ein Trennmittel getrennt. Die beiden Bereiche des Innenraums der Luftdurchtrittsvorrichtung können dabei nebeneinander oder besonders bevorzugterweise übereinander angeordnet sein. Erster und zweiter Bereich beziehen sich dabei auf die Strömungsrichtung der Luft durch die Luftdurchtrittsvorrichtung. Somit ist der zweite Bereich in Strömungsrichtung hinter dem ersten Bereich angeordnet.

Das Trennmittel kann jede geeignete Form und jedes geeignete Material aufweisen. Beispielsweise ist das Trennmittel als Zwischenwand, Blech oder Ähnliches ausgebildet.. Die Luftströmung durch die Luftdurchtrittsvorrichtung ist bevorzugterweise durch beide Bereiche vorgesehen. Dabei ist das erste Luftreinigungsmittel bevorzugterweise im ersten Bereich des Innenraums der Luftdurchtrittsvorrichtung angeordnet. Die zu reinigende Luft wird dem ersten Luftreinigungsmittel zuerst im ersten Bereich zugeführt. Nach dem ersten Reinigungsschritt wird die vom ersten Reinigungsmittel gereinigte Luft weiter in den zweiten Bereich des Innenraums der Luftdurchtrittsvorrichtung geleitet und von dort durch die erste Luftauslassöffnung ausgelassen, beziehungsweise einem Schaltschrank oder Computergehäuse zugeführt.

Das Trennmittel weist bevorzugterweise ein, ganz besonders bevorzugterweise mehrere Luftdurchtrittsöffnungen auf. Somit ist das Trennmittel zur räumlichen Trennung des ersten Bereichs vom zweiten Bereich im Innenraum der Luftdurchtrittsvorrichtung angeordnet, weist aber Luftdurchtrittsöffnungen für die Luftströmung durch die beiden Bereiche des Innenraums der Luftdurchtrittsvorrichtung auf. Beispielsweise kann das Trennmittel bereichsweise als Gitter ausgebildet sein. Besonders bevorzugterweise ist das Trennmittel im mittleren Bereich als Gitter, sowie in den Randbereichen geschlossen ausgebildet. Dabei ist das Trennmittel bevorzugterweise im Wesentlichen luftdicht mit dem Gehäuse, beziehungsweise den Gehäuseinnenwänden, abgeschlossen. Somit ist ein Durchtritt der Luftströmung vom ersten Bereich in den zweiten Bereich vorzugsweise ausschließlich durch die im Trennmittel angeordneten Luftdurchtrittsöffnungen vorgesehen.

Ferner ist bevorzugterweise am Trennmittel das Luftfördermittel, beispielsweise ein Ventilator, angeordnet. Dabei kann das Luftfördermittel im ersten Bereich oder im zweiten Bereich am Trennmittel angeordnet sein. Bevorzugterweise ist dabei vorgesehen, dass das Trennmittel fest mit dem Luftfördermittel verbunden ist. Das Trennmittel dient somit als Halterung für das Luftfördermittel, beispielsweise für den Ventilator. Besonders bevorzugterweise ist das Luftfördermittel im Bereich der Luftdurchtrittsöffnungen des Trennmittels angeordnet.

Außerdem ist bevorzugt, dass der Innenraum der Luftdurchtrittsvorrichtung in Bezug auf die Umgebung einen Unterdruck aufweist. Dabei weist der Innenraum der Luftdurchtrittsvorrichtung zumindest in einem Bereich einen Unterdruck gegenüber der Umgebung auf. Bei Nichtvorhandensein eines Trennmittels weist bevorzugterweise der gesamte Innenraum der Luftdurchtrittsvorrichtung einen Unterdruck gegenüber der Umgebung auf.

Der Innenraum der Luftdurchtrittsvorrichtung kann in Bezug auf den Innenraum des Schaltschrankes oder des Computergehäuses einen Unterdruck aufweisen. Dabei weist der Innenraum der Luftdurchtrittsvorrichtung beispielsweise in einem Bereich einen Unterdruck gegenüber dem Innenraum des Schaltschrankes oder des Computergehäuses auf. Bei Nichtvorhandensein eines Trennmittels weist bevorzugterweise der gesamte Innenraum der Luftdurchtrittsvorrichtung einen Unterdruck gegenüber der Umgebung auf. In diesem Fall wird die gereinigte Luft mittels eines Luftfördermittels in den Innenraum des Schaltschrankes oder des Computergehäuses befördert.

Bevorzugterweise weist der erste Bereich des Innenraums der Luftdurchtrittsvorrichtung in Bezug auf die Umgebung (der Bereich, der die zu reinigende Luft aufweist), beispielsweise in Bezug auf die Umgebungsluft außerhalb der Luftdurchtrittsvorrichtung, einen Unterdruck auf. Ferner ist bevorzugterweise vorgesehen, dass der erste Bereich des Innenraums der Luftdurchtrittsvorrichtung in Bezug auf den zweiten Bereich der Luftdurchtrittsvorrichtung einen Unterdruck aufweist. Unter Umgebung ist der Bereich außerhalb der Luftdurchtrittsvorrichtung, aber nicht das Innere des Schaltschrankes oder des Computergehäuses zu verstehen. Ferner ist unter der Umgebung der Bereich zu verstehen, welcher die zu reinigende Luft, beziehungsweise die der Luftdurchtrittsvorrichtung zuzuführende Luft, aufweist. Beispielsweise handelt es sich hierbei um den Bereich der Umgebungsluft.

Der zweite Bereich des Innenraums der Luftdurchtrittsvorrichtung weist vorzugsweise in Bezug auf den Innenraum des Schaltschrankes und/oder in Bezug auf den ersten Bereich des Innenraums der Luftdurchtrittsvorrichtung einen Überdruck auf.

Zusätzlich zum ersten Luftreinigungsmittel weist die Luftdurchtrittsvorrichtung bevorzugterweise ein zweites Luftreinigungsmittel auf. Das zweite Luftreinigungsmittel ist ferner bevorzugterweise im Innenraum der Luftdurchtrittsvorrichtung angeordnet. Das zweite Luftreinigungsmittel ist in Strömungsrichtung hinter dem ersten Luftreinigungsmittel angeordnet. Besonders bevorzugterweise ist das zweite Luftreinigungsmittel im zweiten Bereich, beispielsweise im Überdruckbereich, in Strömungsrichtung hinter dem Luftfördermittel angeordnet. Das erste Luftreinigungsmittel ist dabei im ersten Bereich des Innenraums der Luftdurchtrittsvorrichtung und somit im Unterdruckbereich des Innenraums der Luftdurchtrittsvorrichtung angeordnet.

Durch das Vorsehen eines zweiten Luftreinigungsmittels kann eine Luftdurchtrittsvorrichtung mit zwei hintereinander geschalteten Reinigungsstufen vorgesehen werden. Somit kann das erste Luftreinigungsmittel zur ersten, beispielsweise gröberen, Reinigung dienen. Das zweite Luftreinigungsmittel, welches in Strömungsrichtung hinter dem ersten Luftreinigungsmittel angeordnet ist, kann somit als zusätzliche und zweite Reinigungsstufe dienen.

Bevorzugterweise weist das zweite Luftreinigungsmittel einen Filter, sowie ganz besonders bevorzugterweise einen wechselbaren Filtereinsatz, wie beispielsweise eine Filtermatte, auf. Dadurch, dass dem zweiten Luftreinigungsmittel ein erstes Luftreinigungsmittel zur groben Luftreinigung vorgeschaltet wird, muss das Filterelement des zweiten Luftreinigungsmittels weniger häufig gewechselt werden. Mit einer derartigen zweistufigen Anordnung von Luftreinigungsmitteln können somit während des Betriebs der Luftdurchtrittsvorrichtung Kosten sowie Abfall gespart werden. Des Weiteren wird im Vergleich zu aus dem Stand der Technik bekannten Vorrichtungen erheblicher Aufwand eingespart, da ein regelmäßiges, beispielsweise tägliches Wechseln von Filterelementen, beispielsweise Filtermatten, aufgrund des vorgeschalteten ersten Luftreinigungsmittels, nicht notwendig ist. Trotzdem kann durch das Vorsehen des zweiten Luftreinigungsmittels eine mindestens genauso hochwertige Filterung realisiert werden.

Dadurch, dass einem zweiten Luftreinigungsmittel, welches bevorzugterweise einen Filter aufweist, ein erstes, bevorzugterweise filterloses, Luftreinigungsmittel vorgeschaltet ist, weist die Luftdurchtrittsvorrichtung einen wesentlich kleineren Druckverlust auf, als Anordnungen, welche lediglich mit Filtern ausgestattet sind. Dies wird dadurch begründet, dass das Filterelement des nachgeschalteten Filters wesentlich weniger, beziehungsweise langsamer, verschmutzt.

Das zweite Luftreinigungsmittel ist bevorzugterweise als Austrittsfilter oder als Filterlüfter ausgebildet.

Das zweite Luftreinigungsmittel kann an jeder geeigneten Stelle der Luftdurchtrittsvorrichtung angeordnet sein. Beispielsweise kann das zweite Luftreinigungsmittel im Bereich des Trennmittels zwischen dem ersten und dem zweiten Bereich des Innenraums der Luftdurchtrittsvorrichtung angeordnet sein. Des Weiten kann das zweite Luftreinigungsmittel im zweiten Bereich, nämlich zwischen dem Trennmittel und der ersten Luftauslassöffnung angeordnet sein. Ferner kann das zweite Luftreinigungsmittel im Bereich der ersten Luftauslassöffnung angeordnet sein. Besonders bevorzugterweise ist das zweite Luftreinigungsmittel als Austrittsfilter oder als Filterlüfter im Bereich der ersten Luftauslassöffnung angeordnet. Unter Austrittsfilter ist ein Filter ohne Ventilator zu verstehen, wobei unter Filterlüfter ein Filter mit Ventilator zu verstehen ist.

Die Luftdurchtrittsvorrichtung weist bevorzugterweise eine zweite Lufteintrittsöffnung für den Einlass der Luft aus dem Innenraum des Schaltschrankes in den Innenraum der Luftdurchtrittsvorrichtung auf. Ferner weist die Luftdurchtrittsvorrichtung bevorzugterweise eine zweite Luftauslassöffnung für den Auslass der aus dem Innenraum des Schaltschrankes in den Innenraum der Luftdurchtrittsvorrichtung zugeführten Luft, vorzugsweise in die Umgebung, auf.

Dabei ist bevorzugterweise vorgesehen, dass die zweite Lufteintrittsöffnung und die zweite Luftaustrittsöffnung durch einen Warmluftkanal miteinander verbunden sind. Somit wird eine räumliche Trennung zwischen der Abluft aus dem Schaltschrank und der kühleren Luft, welche in der Luftdurchtrittsvorrichtung gereinigt und dem Schaltschrank zugeführt wird, erreicht. Der Warmluftkanal kann dabei in jeder geeigneten Weise ausgebildet sein. Der Warmluftkanal verläuft dabei bevorzugterweise von der zweiten Lufteintrittsöffnung zur zweiten Luftaustrittsöffnung durch den Innenraum der Luftdurchtrittsvorrichtung. Dabei ist besonders bevorzugterweise vorgesehen, dass der Warmluftkanal auf direktem Weg, beziehungsweise möglichst kurzem Weg zwischen den beiden Öffnungen verläuft, damit die Länge des Warmluftkanals möglichst kurz gehalten werden kann. Besonders bevorzugterweise verläuft der Warmluftkanal waagerecht, beziehungsweise horizontal. Somit ist besonders bevorzugterweise vorgesehen, dass die zweite Lufteintrittsöffnung und die zweite Luftauslassöffnung im Gehäuse im Wesentliche in derselben Höhe angeordnet sind. Beispielsweise kann die zweite Lufteintrittsöffnung und/oder die zweite Luftauslassöffnung in der oberen oder unteren Hälfte des Gehäuses der Luftdurchtrittsvorrichtung angeordnet sein. Vorzugsweise ist sowohl die zweite Lufteintrittsöffnung sowie auch die zweite Luftauslassöffnung nicht im mittigen Bereich des Gehäuses der Luftdurchtrittsvorrichtung angeordnet ist. Ferner ist bevorzugterweise vorgesehen, dass die zweite Lufteintrittsöffnung und die zweite Luftauslassöffnung an unterschiedlichen Seitenwänden des Gehäuses der Luftdurchtrittsöffnung angeordnet sind. Beispielsweise ist die erste Luftauslassöffnung und die zweite Lufteintrittsöffnung an derselben Seitenwand des Gehäuses der Luftdurchtrittsvorrichtung angeordnet.

Außerdem ist bevorzugterweise vorgesehen, dass die zweite Luftauslassöffnung an der Oberseite und somit nicht an einer Seitenwand des Gehäuses der Luftdurchtrittsvorrichtung angeordnet ist. Dadurch kann die wärmere Abluft nach oben ausgelassen werden. Dies reduziert insbesondere den störenden Einfluss dieser Abluft auf Personen im Bereich der Vorrichtung.

Die zweite Lufteintrittsöffnung, die zweite Luftauslassöffnung und der die beiden Öffnungen verbindende Warmluftkanal können dabei jede geeignete Form, beziehungsweise jeden geeigneten Querschnitt, aufweisen. Beispielsweise können beide Öffnungen sowie der Warmluftkanal mit einem runden, ovalen oder eckigen Querschnitt ausgebildet sein. Ferner ist der Warmluftkanal bevorzugterweise vollständig geschlossen ausgebildet. Somit kann die Warmluft aus dem Schaltschrank oder dem Computergehäuse durch die zweite Lufteintrittsöffnung in den Innenraum der Luftdurchtrittsvorrichtung eintreten, aber nur über die zweite Luftaustrittsöffnung aus der Luftdurchtrittsvorrichtung austreten. Somit ist eine räumliche Trennung zwischen den beiden Luftströmen, dem kälteren Zuluftstrom und dem wärmeren Abluftstrom gewährleistet. Damit der Zuluftstrom nicht durch den wärmeren Abluftstrom erwärmt wird, kann der Warmluftkanal ein isolierendes Material aufweisen. Ferner kann der Warmluftkanal eine zusätzliche Wärmeisolation aufweisen.

Im Warmluftkanal und/oder im Bereich der zweiten Lufteintrittsöffnung, und/oder im Bereich der zweiten Luftaustrittsöffnung kann ein Filterelement zur Filterung der Abluft angeordnet sein.

Erfindungsgemäß ist ferner ein Schaltschrank mit einer vorbeschriebenen Luftdurchtrittsvorrichtung vorgesehen.

Bevorzugterweise ist die Luftdurchtrittsvorrichtung an einer Schaltschrankaußenseite angeordnet. Dabei kann die Luftdurchtrittsvorrichtung in direktem Kontakt mit dem Schaltschrank, beziehungsweise der Schaltschrankaußenseite stehen. Ferner könnte die Luftdurchtrittsvorrichtung und der Schaltschrank eine gemeinsame Seitenwand aufweisen. Somit könnten sich die Luftdurchtrittsvorrichtung und der Schaltschrank eine Seitenwand teilen. Des Weiteren kann die Luftdurchtrittsvorrichtung teilweise oder über dessen gesamte Tiefe in den Schaltschrank eingelassen angeordnet sein.

### Figurenbeschreibung

Die Erfindung wird nun mit Bezug auf die begleitenden Zeichnungen anhand besonders bevorzugter Ausführungsformen beispielhaft erläutert.

Es zeigen schematisch:
- Figur 1: eine perspektivische Ansicht einer Luftdurchtrittsvorrichtung mit darin angeordnetem Fliehkraftabscheider,
- Figur 2a: eine weitere perspektivische Ansicht einer Luftdurchtrittsvorrichtung, wobei der darin angeordnete Fliehkraftabscheider teilweise transparent gezeigt ist,
- Figur 2b: eine weitere perspektivische Ansicht einer Luftdurchtrittsvorrichtung, wobei der darin angeordnete Fliehkraftabscheider teilweise transparent gezeigt ist,
- Figur 3: eine weitere perspektivische Ansicht einer Luftdurchtrittsvorrichtung, wobei der darin angeordnete Fliehkraftabscheider teilweise transparent dargestellt ist, und
- Figur 4: eine perspektivische Ansicht eines Schaltschrankes mit an dessen Außenwand angeordneter Luftdurchtrittsvorrichtung.

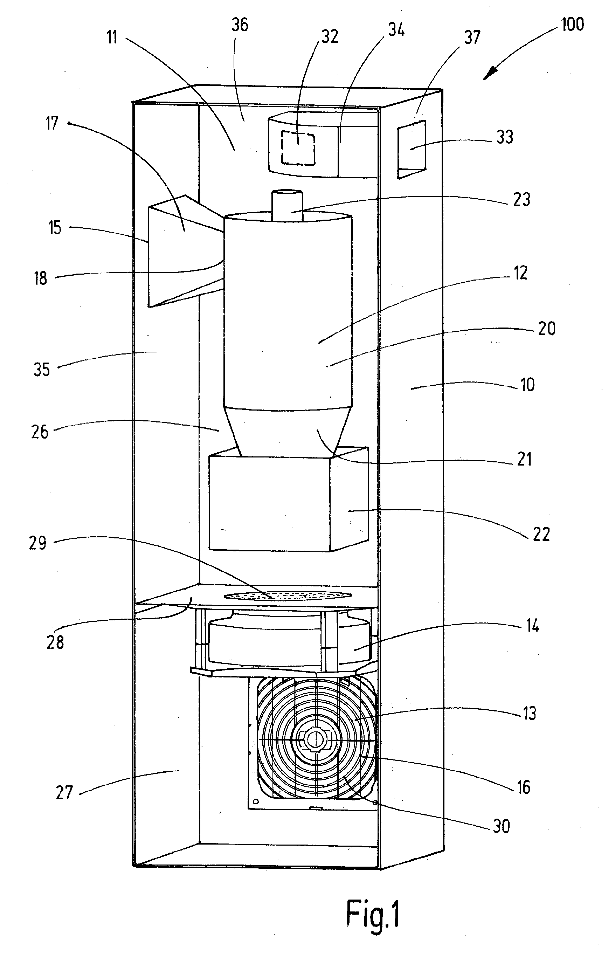

Figur 1 zeigt eine Luftdurchtrittsvorrichtung 100 zur Anordnung an einem Schaltschrank 200. Zur Darstellung der Komponenten innerhalb der Luftdurchtrittsvorrichtung 100 ist die in Figur 1 gezeigte Luftdurchtrittsvorrichtung 100 an einer Seite offen gezeigt. Somit ist die vierte Seitenwand 38 der Luftdurchtrittsvorrichtung 100 in Figur 1 nicht dargestellt.

Die Luftdurchtrittsvorrichtung 100 weist ein Gehäuse 10 mit vier Seitenwänden 35, 36, 37, 38 sowie einer Ober- und einer Unterseite auf. Im oberen Bereich der Luftdurchtrittsvorrichtung 100 ist in der ersten Seitenwand 35 der Luftdurchtrittsvorrichtung 100 eine erste Lufteintrittsöffnung 15 angeordnet. Die erste Lufteintrittsöffnung 15 ist durch einen Eintrittskanal 17 mit der Eintrittsöffnung 18 des ersten Luftreinigungsmittels 12 verbunden. Dabei ist der Eintrittskanal 17 von der ersten Lufteintrittsöffnung 15 hin zur Eintrittsöffnung 18 des ersten Luftreinigungsmittels 12 trichterförmig ausgebildet. Die erste Lufteintrittsöffnung 15 der Luftdurchtrittsvorrichtung 100 ist somit größer als die Eintrittsöffnung 18 des ersten Luftreinigungsmittels 12.

Der Innenraum 11 der Luftdurchtrittsvorrichtung 100 ist durch ein Trennmittel 28 in zwei Bereiche 26, 27 unterteilt. Das Trennmittel 28 ist als Blech mit mittig angeordneten Luftdurchtrittsöffnungen 29 ausgebildet. An der Unterseite des Trennmittels 28, das heißt, im zweiten Bereich 27 des Innenraums 11 der Luftdurchtrittsvorrichtung 100 ist ein Luftfördermittel 14, nämlich ein Ventilator, angeordnet. Aufgrund der räumlichen Trennung des Innenraums 11 der Luftdurchtrittsvorrichtung 100 in zwei Bereiche 26, 27 und das Vorsehen eines Luftfördermittels 14 im zweiten Bereich, weist der erste Bereich 26 des Innenraums 11 der Luftdurchtrittsvorrichtung 100 in Bezug auf die Umgebungsluft einen Unterdruck auf. Der zweite Bereich 27 des Innenraums 11 der Luftdurchtrittsvorrichtung 100 weist in Bezug auf den ersten Bereich 26 sowie in Bezug auf den Innenraum 201 des Schaltschrankes 200 einen Überdruck auf.

Im ersten Bereich 26 des Innenraums 11 der Luftdurchtrittsvorrichtung 100 ist ein erstes Luftreinigungsmittel 12, nämlich ein Fliehkraftabscheider angeordnet. Im zweiten Bereich 27 des Innenraums 11 der Luftdurchtrittsvorrichtung 100 ist ein zweites Luftreinigungsmittel 13, nämlich ein Austrittsfilter 30 im Bereich der ersten Luftauslassöffnung 16 der Luftdurchtrittsvorrichtung 100 angeordnet.

Durch das Luftfördermittel 14, welches am Trennmittel 28 im zweiten Bereich 27 des Innenraums 11 der Luftdurchtrittsvorrichtung 100 angeordnet ist, wird die zu reinigende Umgebungsluft von außen angesaugt. Die Umgebungsluft tritt durch die erste Lufteintrittsöffnung 15 hindurch und durch den Eintrittskanal 17 in den oberen Bereich des Einlaufzylinders 20 des ersten Luftreinigungsmittels 10 hinein. Innerhalb des ersten Luftreinigungsmittels 12, nämlich des Fliehkraftabscheiders, wird die zu reinigende Luft als Träger durch die eigene Strömungsgeschwindigkeit und die konstruktive Ausgestaltung des ersten Luftreinigungsmittels 12 in eine Drehbewegung versetzt. Die auf die Schmutzpartikel wirkende Zentrifugalkraft beschleunigt die Schmutzpartikel radial nach außen. Sie werden somit vom Luftstrom getrennt, wobei der Luftstrom nach innen geleitet und nach oben durch das Tauchrohr 23 des ersten Luftreinigungsmittels 12 in den ersten Bereich 26 des Innenraums 11 der Luftdurchtrittsvorrichtung 100 geführt wird. Aufgrund des Unterdrucks im ersten Bereich 26 des Innenraums 11 der Luftdurchtrittsvorrichtung 100 wird der durch das erste Luftreinigungsmittel 12 gereinigte Luftstrom durch die Luftdurchtrittsöffnung 29 des Trennmittels 28 hindurch in den zweiten Bereich 27 des Innenraums 11 der Luftdurchtrittsvorrichtung 100 geleitet. Vom zweiten Bereich 27 des Innenraums 11 der Luftdurchtrittsvorrichtung 100 wird die in einer ersten Reinigungsstufe vom ersten Reinigungsmittel 12 gereinigte Luft durch die erste Luftauslassöffnung 16 im unteren Bereich der zweiten Seitenwand 36 des Gehäuses 10 der Luftdurchtrittsvorrichtung 100 zum Schaltschrank 200 beziehungsweise in den Innenraum 201 des Schaltschrankes 200 befördert. Da im Bereich der ersten Luftauslassöffnung 16 ein zweites Luftreinigungsmittel 13, nämlich ein Austrittsfilter 30 angeordnet ist, wird die aus dem Innenraum 11 der Luftdurchtrittsvorrichtung 100 austretende Luft nochmals in einer zweiten Stufe gereinigt.

Im oberen Bereich des Gehäuses 10 der Luftdurchtrittsvorrichtung 100 ist in der zweiten Seitenwand 36 der Luftdurchtrittsvorrichtung 100 eine zweite Lufteintrittsöffnung 32 angeordnet. Die zweite Lufteintrittsöffnung 32 ist mit einer, ebenfalls im oberen Bereich des Gehäuses 10 der Luftdurchtrittsvorrichtung 100 in einer dritten Seitenwand 37 der Luftdurchtrittsvorrichtung 100 angeordneten zweiten Luftauslassöffnung 33 durch einen Warmluftkanal 34 verbunden. Durch diese zweite Lufteintrittsöffnung 32 und die durch den Warmluftkanal 34 verbundene zweite Luftauslassöffnung 33 kann warme Abluft aus dem Innenraum 201 des Schaltschrankes 200 in die Umgebung abgeführt werden. Durch das Vorsehen des Warmluftkanals 34 ist dieser Abluftstrom räumlich vom kälteren Zustrom innerhalb der Luftdurchtrittsvorrichtung 100 getrennt.

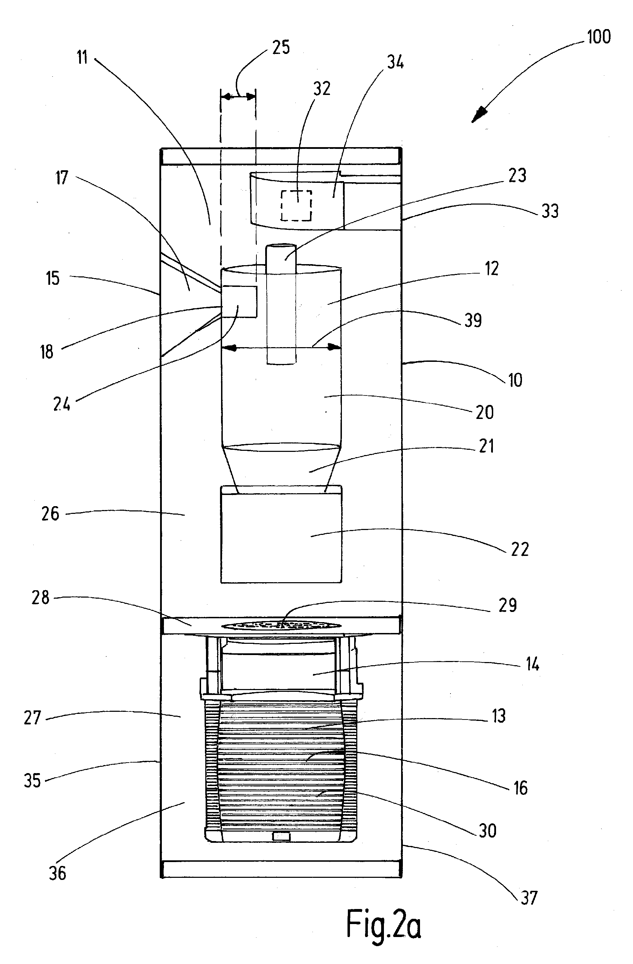

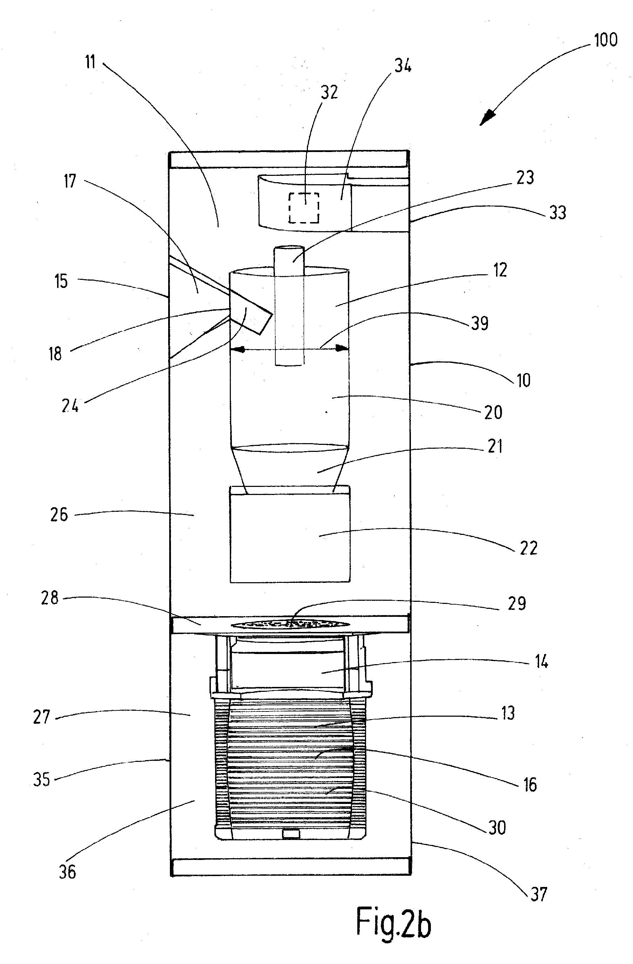

In den Figuren 2a und 2b ist jeweils eine weitere Ansicht der in Figur 1 gezeigten Luftdurchtrittsvorrichtung 100 zu sehen. Dabei ist das erste Luftreinigungsmittel 12 zumindest teilweise transparent dargestellt. Figuren 2a und 2b ist zu entnehmen, dass der Eintrittskanal 17 mit seinem Endbereich 24 über eine erste Länge 25 in den Einlaufzylinder 20 des ersten Luftreinigungsmittels 12 hineinragt. Dabei ist die erste Länge 25, über welche der Eintrittskanal 17 mit dessen Endbereich 24 in den Einlaufzylinder 20 hineinragt, kürzer ausgebildet als die Hälfte des Durchmessers 39 des Einlaufzylinders 20 des ersten Luftreinigungsmittels 12. Das Tauchrohr 23 des ersten Luftreinigungsmittels 12 ist mittig im oberen Bereich des ersten Luftreinigungsmittels 12, beziehungsweise mittig im Einlaufzylinder 20 des ersten Luftreinigungsmittels 12 angeordnet. Der Endbereich 24 des Eintrittskanals 17 ist beabstandet zum Tauchrohr 23 angeordnet.

In Figur 2a ragt der Eintrittskanal 17 mit seinem Endbereich 24 senkrecht gerichtet zur Seitenwand des Einlaufzylinders 20 in den Einlaufzylinder 20 hinein.

In Figur 2b ist der Endbereich 24 des Eintrittskanals 17 innerhalb des Einlaufzylinders 20 schräg nach unten geneigt.

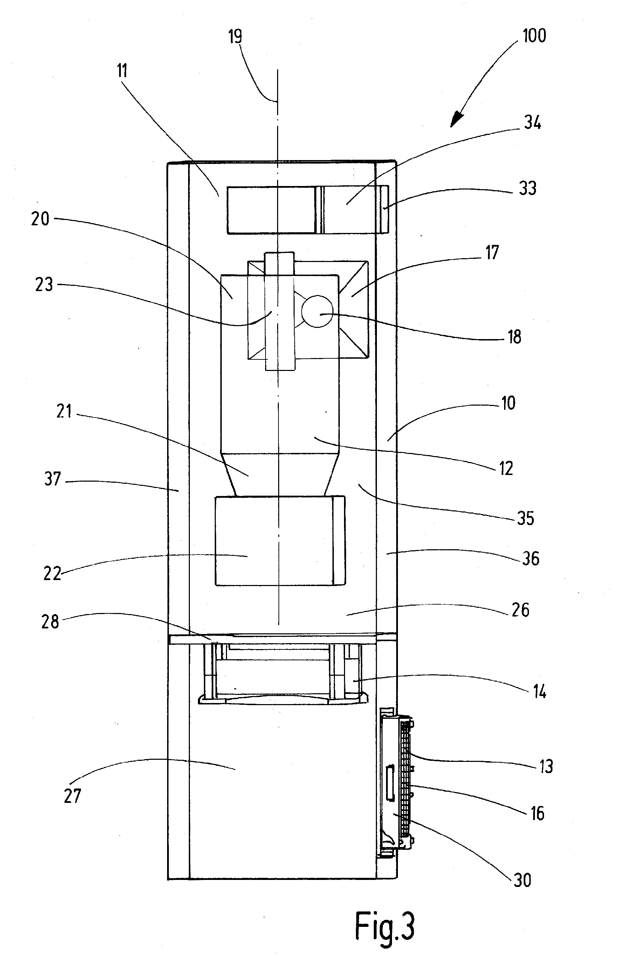

In Figur 3 ist eine weitere Ansicht der Luftdurchtrittsvorrichtung 100 aus Figur 1 gezeigt. Dabei ist, wie in den Figuren 2a und 2b, der Einlaufzylinder 20 des ersten Luftreinigungsmittels 12 transparent dargestellt. Figur 3 ist zu entnehmen, dass in Bezug auf die Längsmittelachse 19 des Einlaufzylinders 20 des ersten Luftreinigungsmittels 12 der Eintrittskanal 17, beziehungsweise der in den Einlaufzylinder 20 hineinragende Endbereich 24 des Eintrittskanals 17 versetzt angeordnet ist. Durch die versetzte Anordnung des Endbereichs 24 des Eintrittskanals 17 zur Längsmittelachse 19 des Einlaufzylinders 20 wird eine tangentiale Einströmung der zu reinigenden Umgebungsluft in den Einlaufzylinder 20 erreicht. Somit strömt die Luft nicht mittig, bezogen auf die Längsmittelachse 19 des Einlaufzylinders 20, in den Einlaufzylinder 20 hinein, sondern wird versetzt auf die Innenwand des Einlaufzylinders 20 des ersten Luftreinigungsmittels 12 geleitet.

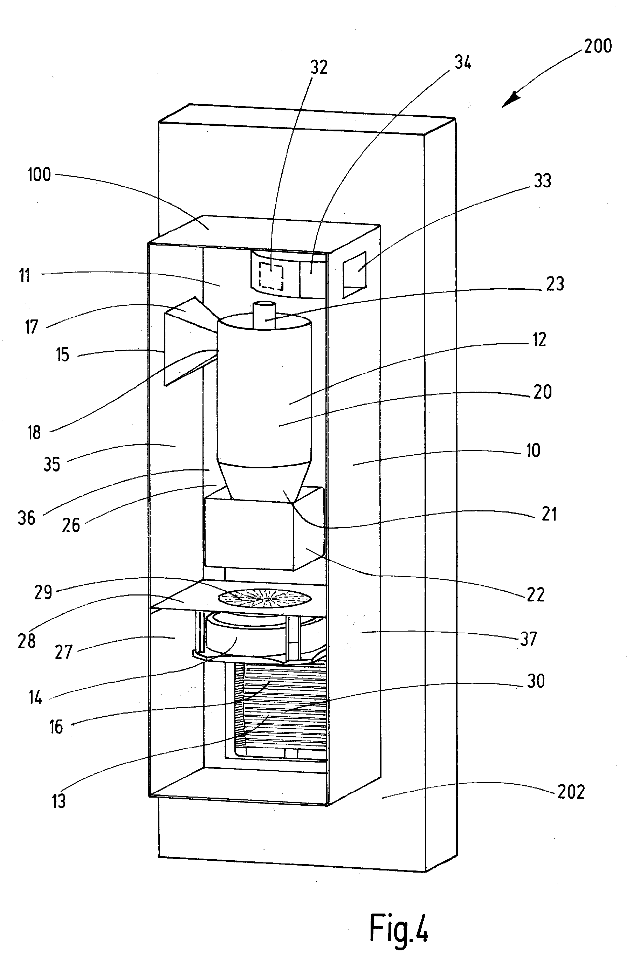

Figur 4 zeigt einen Schaltschrank 200 mit an dessen Außenseite 202 angeordneter Luftdurchtrittsvorrichtung 100. Dabei ist die Luftdurchtrittsvorrichtung 100 mit dessen zweiter Seitenwand 36 fest mit der Schaltschrankaußenseite 202 verbunden.

### Bezugszeichenliste

- 100: Luftdurchtrittsvorrichtung
- 200: Schaltschrank
- 10: Gehäuse der Luftdurchtrittsvorrichtung
- 11: Innenraum der Luftdurchtrittsvorrichtung
- 12: erstes Luftreinigungsmittel
- 13: zweites Luftreinigungsmittel
- 14: Luftfördermittel
- 15: erste Lufteintrittsöffnung
- 16: erste Luftauslassöffnung
- 17: Eintrittskanal
- 18: Eintrittsöffnung des ersten Luftreinigungsmittels
- 19: Längsmittelachse
- 20: Einlaufzylinder des ersten Luftreinigungsmittels
- 21: kegelförmiger Abschnitt des ersten Luftreinigungsmittels
- 22: Partikelauffangbehälter des ersten Luftreinigungsmittels
- 23: Tauchrohr des ersten Luftreinigungsmittels
- 24: Endbereich des Eintrittskanals
- 25: erste Länge
- 26: erster Bereich des Innenraums der Luftdurchtrittsvorrichtung
- 27: zweiter Bereich des Innenraums der Luftdurchtrittsvorrichtung
- 28: Trennmittel
- 29: Luftdurchtrittsöffnungen
- 30: Austrittsfilter
- 31: Filterlüfter
- 32: zweite Lufteintrittsöffnung
- 33: zweite Luftauslassöffnung
- 34: Warmluftkanal
- 35: erste Seitenwand der Luftdurchtrittsvorrichtung
- 36: zweite Seitenwand der Luftdurchtrittsvorrichtung
- 37: dritte Seitenwand der Luftdurchtrittsvorrichtung
- 38: vierte Seitenwand der Luftdurchtrittsvorrichtung
- 39: Durchmesser des Einlaufzylinder des ersten Luftreinigungsmittels

- 201: Innenraum des Schaltschrankes
- 202: Schaltschrankaußenseite

## Patentansprüche

1. Luftdurchtrittsvorrichtung (100) zur Zuführung von Luft, insbesondere Umgebungsluft, in einen Innenraum (201) eines Schaltschrankes (200) oder eines Computergehäuses, wobei die Luftdurchtrittsvorrichtung (100) ein Gehäuse (10) aufweist, wobei die Luftdurchtrittsvorrichtung (100) ein erstes Luftreinigungsmittel (12) zur Reinigung der durch die Luftdurchtrittsvorrichtung durchzuführenden Luft aufweist, wobei am oder im Gehäuse (10) der Luftdurchtrittsvorrichtung (100) ein Luftfördermittel (14) zum Zuführen der von dem ersten Luftreinigungsmittel (12) zu reinigenden Luft zum ersten Luftreinigungsmittel (12) angeordnet ist,
**dadurch gekennzeichnet,**
**dass** das erste Luftreinigungsmittel (12) als Fliehkraftabscheider ausgebildet ist.

2. Luftdurchtrittsvorrichtung (100) gemäß Anspruch 1,
**dadurch gekennzeichnet,**
**dass** die Luftdurchtrittsvorrichtung (100) eine erste Lufteintrittsöffnung (15) für den Einlass der Luft in einen Innenraum (11) der Luftdurchtrittsvorrichtung (100) aufweist, wobei die Luftdurchtrittsvorrichtung (100) eine erste Luftauslassöffnung (16) für den Auslass der gereinigten Luft aus dem Innenraum (11) der Luftdurchtrittsvorrichtung (100) aufweist.

3. Luftdurchtrittsvorrichtung (100) gemäß Anspruch 2,
**dadurch gekennzeichnet,**
**dass** die erste Lufteintrittsöffnung (15) über einen Eintrittskanal (17) mit einer Eintrittsöffnung (18) des ersten Luftreinigungsmittels (12) zur Weiterleitung der Luft an das erste Luftreinigungsmittel (12) verbunden ist, und/oder dass die erste Lufteintrittsöffnung (15) der Luftdurchtrittsvorrichtung (100) größer als eine Eintrittsöffnung (18) des ersten Luftreinigungsmittels (12) ist.

4. Luftdurchtrittsvorrichtung (100) gemäß Anspruch 3,
**dadurch gekennzeichnet,**
**dass** ein Querschnitt des Eintrittskanals (17) von der ersten Lufteintrittsöffnung (15) bis zur Eintrittsöffnung (18) des ersten Luftreinigungsmittels (12) betrachtet abnimmt, wobei der Querschnitt des Eintrittskanals (17) bevorzugterweise stetig abnimmt.

5. Luftdurchtrittsvorrichtung (100) gemäß einem der Ansprüche 3 oder 4,
**dadurch gekennzeichnet,**
**dass** die Eintrittsöffnung (18) des ersten Luftreinigungsmittels (12) oder der Eintrittskanal (17) bezogen auf eine Längsmittelachse (19) des ersten Luftreinigungsmittels (12) und/oder eines Einlaufzylinders (20) des ersten Luftreinigungsmittels (12) zur tangentialen Einströmung der Luft in den Einlaufzylinder (20) des ersten Luftreinigungsmittels (12) versetzt angeordnet ist.

6. Luftdurchtrittsvorrichtung (100) gemäß einem der Ansprüche 3 bis 5,
**dadurch gekennzeichnet,**
**dass** ein Endbereich (24) des Eintrittskanals (17) in das erste Luftreinigungsmittel (12) hineinragt.

7. Luftdurchtrittsvorrichtung (100) gemäß Anspruch 6,
**dadurch gekennzeichnet,**
**dass** der in das erste Luftreinigungsmittel (12) hineinragende Endbereich (24) des Eintrittskanals (17) bezogen auf eine Längsmittelachse (19) des ersten Luftreinigungsmittels (12) und/oder eines Einlaufzylinders (20) des ersten Luftreinigungsmittels (12) zur tangentialen Einströmung der Luft in den Einlaufzylinder (20) des ersten Luftreinigungsmittels (12) versetzt angeordnet ist.

8. Luftdurchtrittsvorrichtung (100) gemäß einem der vorhergehenden Ansprüche,
**dadurch gekennzeichnet,**
**dass** ein Innenraum (11) der Luftdurchtrittsvorrichtung (100) einen ersten Bereich (26) und einen zweiten Bereich (27) aufweist, wobei der erste Bereich (26) von dem zweiten Bereich (27) räumlich durch ein Trennmittel (28) getrennt ist.

9. Luftdurchtrittsvorrichtung (100) gemäß Anspruch 8,
**dadurch gekennzeichnet,**
**dass** das Trennmittel (28) mindestens eine, bevorzugterweise mehrere, Luftdurchtrittsöffnungen (29) aufweist, und/oder dass das Luftfördermittel (14) am Trennmittel (28) angeordnet ist.

10. Luftdurchtrittsvorrichtung (100) gemäß einem der Ansprüche 8 oder 9,
**dadurch gekennzeichnet,**
**dass** der erste Bereich (26) des Innenraums (11) der Luftdurchtrittsvorrichtung (100) in Bezug auf die Umgebung und/oder in Bezug auf den zweiten Bereich (27) des Innenraums (11) der Luftdurchtrittsvorrichtung (100) einen Unterdruck aufweist.

11. Luftdurchtrittsvorrichtung (100) gemäß einem der Ansprüche 8 bis 10,
**dadurch gekennzeichnet,**
**dass** der zweite Bereich (27) des Innenraums (11) der Luftdurchtrittsvorrichtung (100) in Bezug auf den Innenraum (201) des Schaltschrankes (200) und/oder in Bezug auf den ersten Bereich (26) des Innenraums (11) der Luftdurchtrittsvorrichtung (100) einen Überdruck aufweist.

12. Luftdurchtrittsvorrichtung (100) gemäß einem der vorhergehenden Ansprüche,
**dadurch gekennzeichnet,**
**dass** die Luftdurchtrittsvorrichtung (100) ein zweites Luftreinigungsmittel (13) aufweist, welches bevorzugt in Strömungsrichtung hinter dem ersten Luftreinigungsmittel (12) angeordnet ist.

13. Luftdurchtrittsvorrichtung (100) gemäß Anspruch 12,
**dadurch gekennzeichnet,**
**dass** das zweite Luftreinigungsmittel (13) einen Filter, bevorzugterweise eine Filtermatte, aufweist, und/oder dass das zweite Luftreinigungsmittel (13) als Austrittsfilter (30) oder als Filterlüfter (31) ausgebildet ist und bevorzugterweise im Bereich der ersten Luftauslassöffnung (16) angeordnet ist.

14. Luftdurchtrittsvorrichtung (100) gemäß einem der Ansprüche 2 bis 13,
**dadurch gekennzeichnet,**
**dass** die Luftdurchtrittsvorrichtung (100) eine zweite Lufteintrittsöffnung (32) für den Einlass der Luft aus dem Innenraum (201) des Schaltschrankes (200) in den Innenraum (11) der Luftdurchtrittsvorrichtung (100) aufweist, wobei die Luftdurchtrittsvorrichtung (100) eine zweite Luftauslassöffnung (33) für den Auslass der aus dem Innenraum (201) des Schaltschrankes (200) angesaugten Luft aufweist, wobei die zweite Lufteintrittsöffnung (32) und die zweite Luftaustrittsöffnung (33) bevorzugterweise durch einen Warmluftkanal (34) miteinander verbunden sind.

15. Schaltschrank (200), aufweisend eine Luftdurchtrittsvorrichtung (100) gemäß Anspruch 1, wobei die Luftdurchtrittsvorrichtung (100) bevorzugterweise an einer Schaltschrankaußenseite (202) angeordnet ist.
